# EUROPEAN PATENT APPLICATION

(11) **EP 4 822 686 A1**
(43) Date of publication of application: **14.10.2026**
(21) Application number: 25797108.5
(22) Date of filing: 05.03.2025
(51) Int. Cl.: G09G 3/3266

(54) **SHIFT REGISTER UNIT, GATE DRIVING CIRCUIT AND DISPLAY DEVICE**

(30) Priority: 28.04.2024 CN 202410524290
(71) Applicant: Boe Technology Group Co., Ltd., Beijing 100015 (CN); Beijing BOE Display Technology Co., Ltd., Beijing 100176 (CN)
(72) Inventor: CHEN, Gongda, Beijing 100176 (CN); WANG, Shijun, Beijing 100176 (CN); LIU, Jiantao, Beijing 100176 (CN); PENG, Zhou, Beijing 100176 (CN); WEI, Zhan, Beijing 100176 (CN); LIANG, Haiyao, Beijing 100176 (CN); WANG, Yang, Beijing 100176 (CN); DING, Tengfei, Beijing 100176 (CN); ZHANG, Shengfeng, Beijing 100176 (CN); YU, Tianjing, Beijing 100176 (CN); WANG, Jiguo, Beijing 100176 (CN); LIU, Yi, Beijing 100176 (CN); YANG, Xinlan, Beijing 100176 (CN); TAI, Yuke, Beijing 100176 (CN); QIU, Zhangjie, Beijing 100176 (CN); QI, Shengmei, Beijing 100176 (CN)
(74) Representative: Studio Torta S.p.A.
(86) International application number: PCT/CN2025/080848
(87) International publication number: WO 2025/227931

(57) **Abstract**

A shift register unit is provided, comprising: an input circuit, an output circuit, a node potential control circuit, a discharge circuit and a reset circuit. At least one of the input circuit, the output circuit, the node potential control circuit, the discharge circuit and the reset circuit comprises a threshold voltage adjustable transistor. The threshold voltage adjustable transistor comprises a substrate, a gate, a source-drain electrode and a bias electrode, the source-drain electrode is arranged at a side of the substrate facing the gate, the bias electrode is arranged at a side of the substrate facing away from the gate, the bias electrode is configured to receive a bias voltage to adjust a threshold voltage of the threshold voltage adjustable transistor.

## Description

### Technical Field

The application relates to the field of display technology, and more specifically, to a shift register unit, a gate driving circuit comprising the shift register unit, and a display device comprising the gate driving circuit.

### Background

Display devices such as liquid crystal displays and organic light-emitting displays typically include gate drivers located between adjacent pixels in the display area of the display device or in the peripheral non-display area of the display device. The gate drivers include a plurality of cascaded shift register units, which provide scanning signals to gate lines based on input clock signals.

The shift register units in the gate driver sequentially output scanning signals for respective rows of pixels. The stability or reliability of the scanning signals is an important factor affecting the image display quality of the display device. Each shift register unit typically includes a plurality of thin film transistors, and variances in the parameters or performance of the thin film transistors may affect whether the shift register unit outputs scanning signals normally. However, for existing shift register units or gate drivers, little attention has been paid to the adverse effects of changes in the threshold voltage of thin film transistors on the output scanning signals.

### Summary

The embodiments of the application propose a shift register unit, a gate driving circuit comprising the shift register unit, and a display device comprising the gate driving circuit to alleviate the adverse effect of threshold voltage drift or variation of transistors in the shift register unit on the output scanning signal.

According to an embodiment of the application, the shift register unit comprises: an input circuit configured to be electrically connected to an input terminal and a first node, so as to control a potential of the first node based on an input signal received at the input terminal; an output circuit configured to receive a clock signal and be electrically connected to the first node, a second node, an output terminal and a first reference voltage terminal, so as to, under the control of the potential of the first node and a potential of the second node, provide an output signal to the output terminal based on the clock signal; a node potential control circuit configured to be electrically connected to the first node, the second node, the first reference voltage terminal and a second reference voltage terminal, so as to control the potential of the second node based on a second reference voltage at the second reference voltage terminal and the potential of the first node; a discharge circuit configured to be electrically connected to the first node, the second node and the first reference voltage terminal, so as to discharge the first node under the control of the potential of the second node; and a reset circuit configured to receive a reset signal and be electrically connected to the first node, so as to reset the first node under the control of the reset signal. At least one of the input circuit, the output circuit, the node potential control circuit, the discharge circuit and the reset circuit comprises a threshold voltage adjustable transistor, the threshold voltage adjustable transistor comprising a substrate, a gate, a source-drain electrode and a bias electrode, wherein the source-drain electrode is at a side of the substrate facing the gate, the bias electrode is at a side of the substrate facing away from the gate, the bias electrode is configured to receive a bias voltage to adjust a threshold voltage of the threshold voltage adjustable transistor.

In some embodiments, the threshold voltage adjustable transistor further comprises an active layer between the gate and the source-drain electrode, and a base layer for carrying the gate, wherein an orthographic projection of the bias electrode on the base layer covers an orthographic projection of the active layer on the base layer.

In some embodiments, the threshold voltage adjustable transistor further comprises a gate insulation layer, the gate insulation layer is between the source-drain electrode and the base layer and covers the gate.

In some embodiments, the shift register unit further comprises a threshold voltage compensation transistor and a bias voltage receiving terminal for receiving the bias voltage, a control terminal of the threshold voltage compensation transistor is electrically connected to one of a control terminal of the threshold voltage adjustable transistor, the input terminal, an output terminal of the output circuit, wherein a first terminal and a second terminal of the threshold voltage compensation transistor are electrically connected to the bias voltage receiving terminal and the bias electrode of the threshold voltage adjustable transistor respectively.

In some embodiments, the shift register unit further comprises a switch transistor connected in series with the threshold voltage compensation transistor, the switch transistor is configured to control whether the bias voltage is provided to the bias electrode of the threshold voltage adjustable transistor via the threshold voltage compensation transistor.

In some embodiments, the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal, a control terminal of the first compensation transistor is electrically connected to a control terminal of the first type transistor, a first terminal and a second terminal of the first compensation transistor are electrically connected to the first voltage receiving terminal and the bias electrode of the first type transistor respectively, a control terminal of the second compensation transistor is electrically connected to a control terminal of the second type transistor, a first terminal and a second terminal of the second compensation transistor are electrically connected to the second voltage receiving terminal and the bias electrode of the second type transistor respectively, wherein the first voltage receiving terminal and the second voltage receiving terminal are respectively configured to receive a first voltage and a second voltage different from each other.

In some embodiments, the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal. A control terminal of the first compensation transistor and a control terminal of the second compensation transistor are electrically connected to one of the first node, an input terminal of the input circuit or an output terminal of the output circuit, a first terminal and a second terminal of the first compensation transistor are electrically connected to the first voltage receiving terminal and the bias electrode of the first type transistor respectively, a first terminal and a second terminal of the second compensation transistor are electrically connected to the second voltage receiving terminal and the bias electrode of the second type transistor respectively, wherein the first voltage receiving terminal and the second voltage receiving terminal are respectively configured to receive a first voltage and a second voltage different from each other.

In some embodiments, the shift register unit comprises a base plate for carrying the input circuit, the output circuit, the node potential control circuit, the discharge circuit and the reset circuit, the base plate comprises a first area for arranging the first type transistor and a second area for arranging the second type transistor.

In some embodiments, the switch transistor comprises a first switch transistor connected in series with the first compensation transistor and a second switch transistor connected in series with the second compensation transistor, a control terminal of the first switch transistor and a control terminal of the second switch transistor are electrically connected to a compensation enablement terminal providing a compensation enablement signal.

In some embodiments, the input circuit comprises a first transistor, a control terminal of the first transistor is electrically connected to the input terminal, a first terminal of the first transistor is electrically connected to the input terminal or a first control signal terminal, a second terminal of the first transistor is electrically connected to the first node, the reset circuit comprises a second transistor, a control terminal of the second transistor is configured to receive a reset signal, a first terminal of the second transistor is electrically connected to the first node, a second terminal of the second transistor is electrically connected to a second control signal terminal or the first reference voltage terminal, the output circuit comprises a third transistor, a fourth transistor and a capacitor, a control terminal of the third transistor is electrically connected to the first node, a first terminal of the third transistor is configured to receive the clock signal, a second terminal of the third transistor is electrically connected to the output terminal, a control terminal of the fourth transistor is electrically connected to the second node, a first terminal and a second terminal of the fourth transistor are electrically connected to the output terminal and the first reference voltage terminal respectively, the capacitor is electrically connected between the first node and the output terminal, the node potential control circuit comprises fifth transistor and a sixth transistor, a control terminal and a first terminal of the fifth transistor is electrically connected to the second reference voltage terminal, a second terminal of the fifth transistor is electrically connected to the second node, a control terminal of the sixth transistor is electrically connected to the first node, a first terminal and a second terminal of the sixth transistor are electrically connected to the second node and the first reference voltage terminal respectively, the discharge circuit comprises a seventh transistor, a control terminal of the seventh transistor is electrically connected to the second node, a first terminal and a second terminal of the first transistor are electrically connected to the first node and the first reference voltage terminal respectively. The first type transistor comprises the second transistor, the third transistor and the seventh transistor, the second type transistor comprises the first transistor.

In some embodiments, the base plate further comprises a third area, the fourth transistor, the fifth transistor and the sixth transistor are arranged in the third area.

Another embodiment of the application provides a gate driving circuit comprising a plurality of cascaded shift register units, each shift register unit is as defined in any one of the foregoing embodiments. The gate driving circuit further comprises a threshold voltage compensation circuit, the threshold voltage compensation circuit comprising a threshold voltage compensation transistor and a bias voltage receiving terminal for receiving the bias voltage. A control terminal of the threshold voltage compensation transistor is electrically connected to one of the output terminal, the input terminal or the first node of the shift register unit, a first terminal and a second terminal of the threshold voltage compensation transistor are electrically connected to the bias voltage receiving terminal and the bias electrode of the threshold voltage adjustable transistor in the shift register unit respectively.

In some embodiments, the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal, wherein a control terminal of the first compensation transistor and a control terminal of the second compensation transistor are electrically connected to one of the output terminal, the input terminal or the first node of each shift register unit, a first terminal and a second terminal of the first compensation transistor are electrically connected to the first voltage receiving terminal and the bias electrode of the first type transistor respectively, a first terminal and a second terminal of the second type transistor are electrically connected to the second voltage receiving terminal and the bias electrode of the second type transistor respectively, the first voltage receiving terminal and the second voltage receiving terminal are respectively configured to receive a first voltage and a second voltage different from each other.

In some embodiments, the threshold voltage compensation circuit further comprises a first switch transistor connected in series with the first compensation transistor and a second switch transistor connected in series with the second compensation transistor, a control terminal of the first switch transistor and a control terminal of the second switch transistor are electrically connected to a compensation enablement terminal providing a compensation enablement signal.

In some embodiments, each shift register unit comprises a base plate for carrying the input circuit, the output circuit, the node potential control circuit, the discharge circuit and the reset circuit, the base plate comprising a first area for arranging the first type transistor and a second area for arranging the second type transistor.

Another embodiment of the application provides a display device comprising the gate driving circuit as defined in any one of the foregoing embodiments.

Based on the description below, these and other advantages of the application will become clear, and will be elucidated with reference to the embodiments described below.

### Brief Description of Drawings

Embodiments of the application will now be described in more detail and with reference to the accompanying drawings, wherein:
Figure 1A illustrates a circuit structure diagram of a shift register unit according to an embodiment of the application;
Figure 1B illustrates a partial cross-sectional view of a threshold voltage adjustable transistor in a shift register unit;
Figure 2A illustrates a specific circuit schematic diagram of a shift register unit according to an embodiment of the application;
Figure 2B illustrates a signal timing diagram for the shift register unit as shown in Figure 2A of the application;
Figure 3 illustrates a specific circuit schematic diagram of a shift register unit according to another embodiment of the application;
Figure 4 illustrates a specific circuit schematic diagram of a shift register unit according to a further embodiment of the application;
Figure 5 illustrates the electrical connection between the threshold voltage adjustable transistor and the threshold voltage compensation transistor in the shift register unit according to an embodiment of the application;
Figure 6 illustrates the electrical connection between the threshold voltage adjustable transistor and the threshold voltage compensation transistor in the shift register unit according to another embodiment of the application;
Figure 7 illustrates the electrical connections among the threshold voltage adjustable transistor, the threshold voltage compensation transistor, and the switch transistor in the shift register unit according to another embodiment of the application;
Figure 8 illustrates the electrical connections among the threshold voltage adjustable transistor, the threshold voltage compensation transistor, and the switch transistor in the shift register unit according to a further embodiment of the application;
Figure 9 illustrates a partial planar structure diagram of a display device according to an embodiment of the application;
Figure 10 illustrates the electrical connection between the first compensation transistor and the first type transistor, as well as the electrical connection between the second compensation transistor and the second type transistor of the shift register unit according to an embodiment of the application;
Figure 11 illustrates a partial circuit diagram of a shift register unit according to another embodiment of the application;
Figure 12 illustrates a partial circuit diagram of a shift register unit according to another embodiment of the application;
Figure 13 illustrates the partition layout for respective transistors in the shift register unit;
Figure 14 illustrates a plurality of cascaded shift register units;
Figure 15 illustrates the electrical connection between the threshold voltage adjustable transistor and the corresponding threshold voltage compensation transistor in two cascaded shift register units; and
Figure 16 illustrates two shift register units and a threshold voltage compensation circuit in the gate driving circuit.

### Detailed Description of Embodiments

The following description provides specific details of various embodiments of the application, so that those skilled in the art can fully understand and implement the embodiments of the application. In some cases, the application does not illustrate or describe in detail some well-known structures or functions in the art to avoid obscuring the description of the embodiments. The technical solution of the application can be embodied in many different forms and purposes, and should not be limited to the embodiments described herein. These embodiments are provided to make the technical solution of the application clear and complete, but the embodiments do not limit the protection scope of the present patent application.

In the following description, a large number of specific details are provided to provide a thorough understanding of the invention. However, it is obvious to those skilled in the art that the technical solution of the application can be implemented without one or more of these details. Detailed steps and structures are provided in the following description to set forth the technical solution proposed by the present application. The terms mentioned in the application should be understood in their broadest and most reasonable manner, even if they are used in conjunction with specific embodiments of the application.

Here, some terms used in the embodiments of the application will be explained to facilitate understanding by those skilled in the art.

The "control terminal" mentioned herein refers to the gate of the transistor for receiving scanning signals. The transistor can be in a conducting state or turned-off state under the control of the signal received at its control terminal. The "first terminal" mentioned herein refers to one of the two terminals of the transistor other than the control terminal, and the "second terminal" refers to the other of the two terminals of the transistor other than the control terminal. That is, the first terminal refers to one of the source and the drain of the transistor, and the second terminal is the other of the source and the drain of the transistor. The "display device" mentioned herein can be a complete display product with image display function, or it can be a component of the complete display product, but this component includes the shift register unit or gate driving circuit described in the embodiments of the application.

An embodiment of the application provides a shift register unit comprising an input circuit, an output circuit, a node potential control circuit, a discharge circuit and a reset circuit. The input circuit is configured to be electrically connected to an input terminal and a first node, so as to control a potential of the first node based on an input signal received at the input terminal. The output circuit is configured to receive a clock signal and be electrically connected to the first node, a second node, an output terminal and a first reference voltage terminal, so as to, under the control of the potential of the first node and a potential of the second node, provide an output signal to the output terminal based on the clock signal. The node potential control circuit is configured to be electrically connected to the first node, the second node, the first reference voltage terminal and a second reference voltage terminal, so as to control the potential of the second node based on a second reference voltage at the second reference voltage terminal and the potential of the first node. The discharge circuit is configured to be electrically connected to the first node, the second node and the first reference voltage terminal, so as to discharge the first node under the control of the potential of the second node. The reset circuit is configured to receive a reset signal and be electrically connected to the first node, so as to reset the first node under the control of the reset signal. At least one of the input circuit, the output circuit, the node potential control circuit, the discharge circuit and the reset circuit comprises a threshold voltage adjustable transistor, the threshold voltage adjustable transistor comprises a substrate, a gate, a source, a drain and a bias electrode, the source and the drain are arranged at a side of the substrate facing the gate, the bias electrode is arranged at a side of the substrate facing away from the gate, the bias electrode is configured to receive a bias voltage so as to adjust a threshold voltage of the threshold voltage adjustable transistor.

The inventors of the application realize that the threshold voltage of a transistor is related to its substrate bias voltage. Taking an N-type metal oxide transistor as an example, if the substrate and the source of the transistor are connected to the ground, the voltage difference V_{SB} between the source and the substrate is zero, and the threshold voltage of the transistor is Vₜₕ₀. When the substrate voltage V_{B} drops to a negative potential less than zero, more positively charged holes will be attracted to the vicinity of the substrate, leaving a large amount of immovable negative charges below the gate, resulting in an increase in the width of the depletion layer. As the substrate bias voltage decreases, the total number of charges in the depletion layer increases, leading to an increase in the threshold voltage Vₜₕ, which is known as the transistor body effect. When considering the body effect, the threshold voltage of metal oxide transistors can be expressed as the following formula: ${V}_{th} = {V}_{tho} + γ \left(\sqrt{\left|2{∅}_{F}+{V}_{SB}\right|}-\sqrt{\left|2{∅}_{F}\right|}\right)$ where Vₜₕ₀ is the threshold voltage of the transistor when the voltage difference between the source and the substrate is zero, γ is the body effect factor, which is a constant and related to the manufacturing process for the transistor, and Ø_{F} is the built-in potential.

Therefore, when the substrate bias voltage V_{B} is a relatively large positive voltage, it can cause the voltage difference V_{SB} between the source and the substrate to be less than 0, and the threshold voltage Vₜₕ of the transistor decreases. When the substrate bias voltage V_{B} is a relatively large negative voltage, it can cause the voltage difference V_{SB} between the source and the substrate to be greater than 0, and the threshold voltage Vₜₕ of the transistor increases. According to the body effect, the threshold voltage of the transistor can be adjusted by controlling the substrate bias voltage V_{B} of the transistor.

For the shift register unit provided by the embodiments of the application, at least one of the input circuit, output circuit, node potential control circuit, discharge circuit and reset circuit includes a threshold voltage adjustable transistor. In other words, among the transistors included in the shift register unit, there is at least one threshold voltage adjustable transistor, which includes the aforementioned bias electrode. The threshold voltage adjustable transistor can receive a bias voltage through the bias electrode, thereby adjusting the threshold voltage of the threshold voltage adjustable transistor. Especially, after the shift register unit operating for a period of time, at least some transistors in the shift register unit may experience threshold voltage drift. In the case where the shift register unit includes a threshold voltage adjustable transistor, applying an appropriate bias voltage to the bias electrode of the threshold voltage adjustable transistor can improve the threshold voltage drift, promote the stability of the threshold voltage of the transistors in the shift register unit, thereby enhancing the stability and reliability of the output signal of the shift register unit, and improving the quality of the image displayed by the display device comprising the shift register unit.

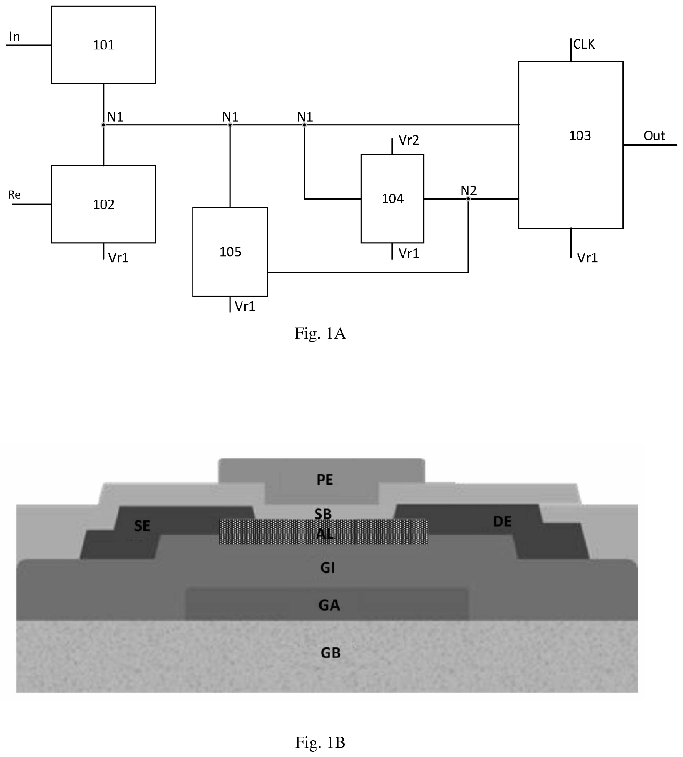

Figure 1A schematically shows a circuit structure diagram of a shift register unit. As shown in Figure 1A, the shift register unit comprises an input circuit 101, an output circuit 103, a node potential control circuit 104, a discharge circuit 105 and a reset circuit 102. The input circuit 101 is configured to be electrically connected to the input terminal In and a first node N1, so as to control the potential of the first node N1 based on the input signal received at the input terminal. The output circuit 103 is configured to receive the clock signal CLK and be electrically connected to the first node N1, the second node N2, the output terminal Out and the first reference voltage terminal Vr1, so as to, under the control of the potential of the first node N1 and the potential of the second node N2, provide an output signal to the output terminal Out based on the clock signal CLK. The node potential control circuit 104 is configured to be electrically connected to the first node N1, the second node N2, the first reference voltage terminal Vr1 and the second reference voltage terminal Vr2, so as to control the potential of the second node N2 based on the second reference voltage at the second reference voltage terminal Vr2 and the potential of the first node N1. The discharge circuit 105 is configured to be electrically connected to the first node N1, the second node N2 and the first reference voltage terminal Vr1, so as to discharge the first node N1 under the control of the potential of the second node N2. The reset circuit 102 receives the reset signal Re and is electrically connected to the first node N1, so as to reset the first node N1 under the control of the reset signal Re. The application does not impose specific limitations on the specific circuits of the shift register unit. In other words, the input circuit 101, the output circuit 103, the node potential control circuit 104, the discharge circuit 105, and the reset circuit 102 may be embodied in any specific form of circuit structure, as long as each circuit unit in the shift register unit achieves its corresponding function.

As mentioned above, in the embodiments of the application, at least one transistor in the shift register unit include a bias electrode for receiving a bias voltage, thereby adjusting the threshold voltage of the transistor. Herein, such a transistor is referred to as a threshold voltage adjustable transistor. Figure 1B schematically shows an example of a partial cross-sectional view of a threshold voltage adjustable transistor. As shown in Figure 1B, the threshold voltage adjustable transistor comprises a substrate SB, a gate GA, a source-drain electrode (including a source electrode SE and a drain electrode DE) and a bias electrode PE. The source-drain electrode is arranged at a side of the substrate SB facing the gate GA, the bias electrode PE is arranged at a side of the substrate SB facing away from the gate GA, and the bias electrode PE is configured to receive the bias voltage so as to adjust the threshold voltage of the threshold voltage adjustable transistor.

In some embodiments, the threshold voltage adjustable transistor further comprises an active layer between the gate and the source-drain electrode, and a base layer for carrying the gate. The orthographic projection of the bias electrode on the base layer covers the orthographic projection of the active layer on the base layer. Further, the threshold voltage adjustable transistor further comprises a gate insulation layer, which is located between the source-drain electrode and the base layer and covers the gate. In some embodiments, the substrate SB includes insulation material, which can be the same as the material of the gate insulation layer.

As shown in Figure 1B, the threshold voltage adjustable transistor includes a base layer GB (e.g. a glass base made of glass material) and a gate insulation layer GI. The gate insulation layer GI is between the source-drain electrode SE, DE and the gate GA, the base layer GB is located at a side of the gate GA facing away from the source-drain electrode to carry the gate GA. In fact, all other layer structures of the threshold voltage adjustable transistor can be carried by the base layer GB. The material of the bias electrode includes but is not limited to indium tin oxide (ITO) or metal film layer.

In some embodiments, as shown in Figure 1B, the threshold voltage adjustable transistor includes an active layer AL between the gate GA and the source-drain electrode SE, DE, and the orthographic projection of the bias electrode PE on the base layer GB covers the orthographic projection of the active layer AL on the base layer GB. That is to say, in this embodiment, the bias electrode PE is above the active layer AL and has a large coverage area. The orthographic projection of the bias electrode PE on the base layer GB covering the orthographic projection of the active layer AL on the base layer GB means that the channel region of the threshold voltage adjustable transistor falls within the coverage area of the bias electrode, thereby enhancing the ability to adjust the threshold voltage of the threshold voltage adjustable transistor through the bias electrode using the bias voltage.

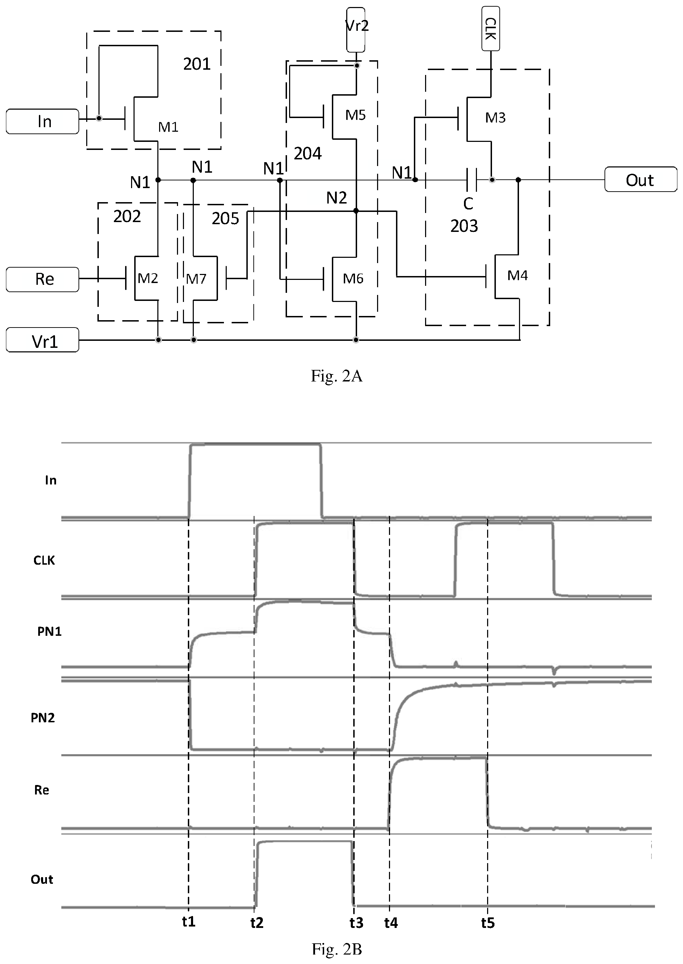

Figure 2A illustrates a specific circuit schematic diagram of a shift register unit. As shown in Figure 2A, the shift register unit comprises an input circuit 201, an output circuit 203, a node potential control circuit 204, a discharge circuit 205 and a reset circuit 202. The input circuit 201 includes a first transistor M1, one of the first terminal and the second terminal of the first transistor M1 is electrically connected to its control terminal, the other of the first terminal and second terminal of the first transistor is electrically connected to the first node N1, the control terminal of the first transistor receives the input signal In. In another embodiment, unlike the one shown in Figure 2A, one of the first and second terminals of the first transistor M1 is electrically connected to the first node N1, and the other of the first and second terminals of the first transistor M1 is not electrically connected to its control terminal, but electrically connected to an appropriate fixed potential or pulse signal, as long as the first transistor M1 is turned on when the control terminal thereof receives an effective level of the input signal. The reset circuit 202 includes a second transistor M2, whose control terminal receives a reset signal Re. One of the first and second terminals of the second transistor M2 is electrically connected to the first node N1, and the other of the first and second terminals of the second transistor M2 is electrically connected to the first reference voltage terminal to receive the first reference voltage Vr1. The second transistor M2 and the first transistor M1 are actually connected in series. The output circuit 203 includes a third transistor M3, a fourth transistor M4, and a capacitor C. One of the first and second terminals of the third transistor M3 is electrically connected to the output terminal, and the other of the first and second terminals of the third transistor M3 is configured to receive the clock signal CLK. The control terminal of the third transistor M3 is electrically connected to the first node N1, and the capacitor C is electrically connected between the first node N1 and the output terminal. One of the first and second terminals of the fourth transistor M4 is electrically connected to the output terminal, the other of the first and second terminals of the fourth transistor M4 is electrically connected to the first reference voltage terminal, and the control terminal of the fourth transistor M4 is electrically connected to the second node N2. The node potential control circuit 204 includes a fifth transistor M5 and a sixth transistor M6. One of the first and second terminals of the fifth transistor M5 is electrically connected to its control terminal, and the control terminal is also electrically connected to the second reference voltage terminal to receive the second reference voltage Vr2, the other of the first and second terminals of the fifth transistor M5 is electrically connected to the second node N2. One of the first and second terminals of the sixth transistor M6 is electrically connected to the second node N2, the other of the first and second terminals of the sixth transistor M6 is electrically connected to the first reference voltage terminal, and the control terminal of the sixth transistor M6 is electrically connected to the first node N1. The discharge circuit 205 includes a seventh transistor M7, the control terminal of which is electrically connected to the second node N2, one of the first and second terminals of the seventh transistor is electrically connected to the first node N1, and the other of the first and second terminals of the seventh transistor is electrically connected to the first reference voltage terminal. Thus it can be seen that the third transistor M3 and the fourth transistor M4 are actually connected in series between a clock signal receiving terminal and the first reference voltage terminal, while the fifth transistor M5 and the sixth transistor M6 are actually connected in series between the second reference voltage terminal and the first reference voltage terminal.

Figure 2B illustrates an example of a signal timing diagram for the shift register unit as shown in Figure 2A. In this example, each transistor in the shift register unit shown in Figure 2A is an N-type thin film transistor (e.g. NMOS transistor), and the first reference voltage Vr1 received at the first reference voltage terminal is a constant low-level voltage, while the second reference voltage Vr2 received at the second reference voltage terminal is a constant high-level voltage. Figure 2B illustrates a signal timing diagram within one cycle. As shown in Figure 2B, starting from time t1, the shift register unit receives an effective input signal, that is, the input signal In changes from a low level to a high level at time t1. Accordingly, the control terminal of the first transistor M1 receives a high-level signal and the first transistor M1 is turned on, and the capacitor C is charged. The potential PN1 of the first node N1 jumps from an initial low potential to a first high potential. The third transistor M3 and the sixth transistor M6 are turned on, and at this time, the potential PN2 of the second node N2 is the first reference voltage of the first reference voltage terminal, that is, the potential PN2 of the second node N2 is at a low level. Therefore, the fourth transistor M4 and the seventh transistor M7 are in an off state. Due to the clock signal CLK remaining at a low level at this time, the output signal Out at the output terminal of the shift register unit remains at a low level. In addition, the reset signal Re remains at a low level at this time, so the second transistor M2 is in an off state. At time t2, the clock signal CLK jumps from a low level to a high level. Due to the bootstrap effect of the capacitor C, the potential PN1 of the first node N1 is raised from the first high potential to a second higher potential. The third transistor M3 and the sixth transistor M6 remain in a conducting state, the potential PN2 of the second node N2 remains at a low level, and the fourth transistor M4 and the seventh transistor M7 remain in an off state. The output signal Out at the output terminal of the shift register unit jumps from a low level to a high level. At time t3, the clock signal CLK changes from a high level to a low level, and the output signal Out also changes from a high level to a low level accordingly. Similarly, due to the bootstrap effect of the capacitor C, the potential PN1 of the first node N1 decreases from the second higher potential. When the potential PN1 of the first node N1 drops to a low level (at time t4), the third transistor M3 and the sixth transistor M6 are turned off, and the potential PN2 of the second node N2 is not determined by the first reference voltage at the first reference voltage terminal, changing from the previous low level to a high level. The potential PN2 of a high level causes the fourth transistor M4 and the seventh transistor M7 to be turned on, thereby maintaining the output signal Out at a low level. In addition, the first node N1 discharges to the first reference voltage terminal via the seventh transistor M7, reducing or clearing the charges accumulated on the first node N1. The second transistor M2 receives an effective reset signal Re (a high level between time t4 and time t5) at time t4 and thus is turned on, ensuring that the output of the shift register unit is not affected by changes in the clock signal.

The shift register unit as shown in Figure 2A can be applied to a gate driving circuit, which may include a plurality of cascaded shift register units as shown in Figure 2A. The output signal of each shift register unit can be provided as a scanning signal to one of the gate lines of the display device. For example, the output signal of each shift register unit can be used as a row scanning signal to turn on a row of pixels. The effective level (e.g. high level) of the output signal of each shift register unit arrives in chronological order, thereby achieving row scanning of the pixels in each row of the display device.

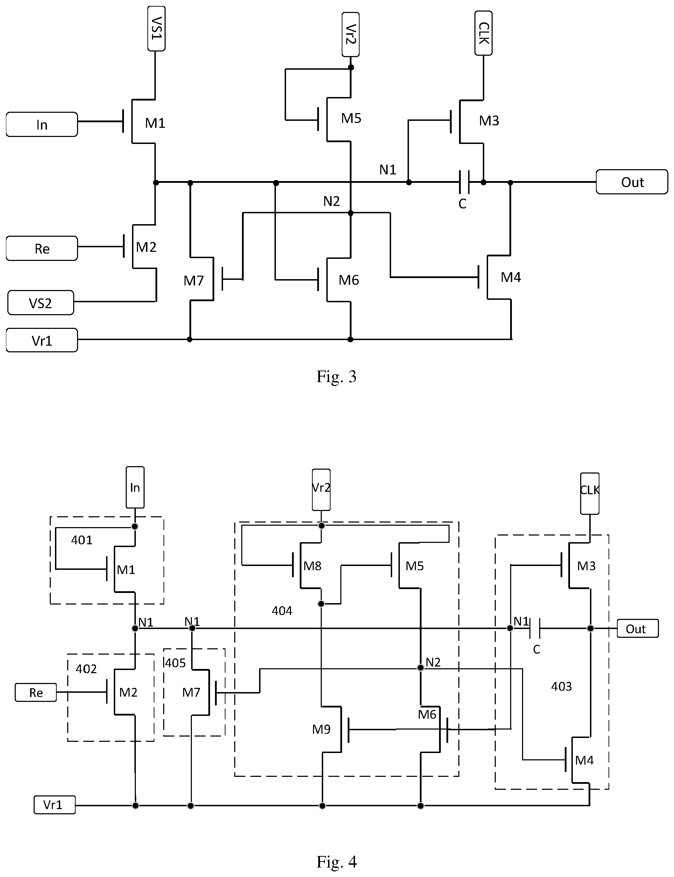

Figure 3 illustrates a variant embodiment based on Figure 2A. In this embodiment, the input circuit is not only electrically connected to the input terminal and the first node N1, but also electrically connected to a first signal terminal to receive a first signal VS1. The reset circuit receives the reset signal and is also electrically connected to the first node N1 and a second signal terminal to receive a second signal VS2. The other circuits of the shift register unit are basically the same as the embodiment shown in Figure 2A. The first signal VS1 and the second signal VS2 can be adjusted, for example, the first signal VS1 and the second signal VS2 can be set as a high-level signal and a low-level signal respectively, or the first signal VS1 and the second signal VS2 can be set as a low-level signal and a high-level signal respectively. The gate driving circuit applying the shift register unit shown in Figure 2A may achieve unidirectional scanning of multiple rows of pixels. By changing the levels of the first signal VS1 and the second signal VS2, the gate driving circuit applying the shift register unit shown in Figure 3 may achieve bidirectional scanning of multiple rows of pixels (e.g., from top to bottom or from bottom to top).

Figure 4 shows another example of a shift register unit, which includes an input circuit 401, a reset circuit 402, a discharge circuit 405, a node potential control circuit 404, and an output circuit 403. In this example, the node potential control circuit 404 includes a fifth transistor M5 and a sixth transistor M6 connected in series between the second reference voltage terminal and the first reference voltage terminal, an eighth transistor M8 and a ninth transistor M9 connected in series between the second reference voltage terminal and the first reference voltage terminal. The control terminals of the sixth transistor M6 and the ninth transistor M9 are both electrically connected to the first node N1. One of the first and second terminals of the eighth transistor M8 is electrically connected to its control terminal, and the other of the first and second terminals of the eighth transistor M8 is electrically connected to the control terminal of the fifth transistor. The connection node between the fifth transistor M5 and the sixth transistor M6 forms the second node N2. The connection of the first transistor M1, the second transistor M2, the seventh transistor M7, the third transistor M3, and the fourth transistor M4 in the shift register unit is basically the same as the embodiment shown in Figure 2A, and will not be repeated here. For the shift register unit shown in Figure 4, the second reference voltage Vr2 received at the second reference voltage terminal is not a constant high-level voltage, but another clock signal complementary to the clock signal CLK. In the case where the clock signal CLK is a square wave signal, the second reference voltage Vr2 is a square wave signal with the same duty cycle as the clock signal CLK but opposite phase.

According to some embodiments of the application, the shift register unit further comprises a threshold voltage compensation transistor and a bias voltage receiving terminal for receiving the bias voltage. The control terminal of the threshold voltage compensation transistor is electrically connected to one of the control terminal of the threshold voltage adjustable transistor, the output terminal of the output circuit and the input terminal. The first and second terminals of the threshold voltage compensation transistor are electrically connected to the bias voltage receiving terminal and the bias electrode of the threshold voltage adjustable transistor respectively.

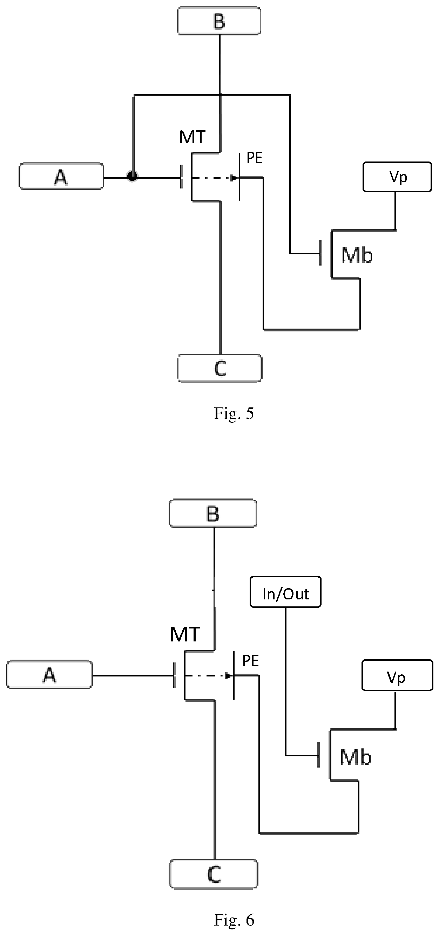

Figures 5 and 6 illustrate examples of the electrical connection relationship between the threshold voltage adjustable transistor and the threshold voltage compensation transistor in the shift register unit. The threshold voltage adjustable transistor can be any transistor in the shift register unit, which is uniformly represented by the reference sign MT, the control terminal of the threshold voltage adjustable transistor is indicated with the reference sign A, and the first and second terminals of the threshold voltage adjustable transistor are indicated with the reference signs B and C, respectively. The bias electrode of the threshold voltage adjustable transistor for receiving the bias voltage is represented by the reference sign PE. As shown in Figure 5, the control terminal of the threshold voltage compensation transistor Mb is electrically connected to the control terminal of the threshold voltage adjustable transistor MT. The first and second terminals of the threshold voltage compensation transistor Mb are electrically connected to the bias voltage receiving terminal Vp and the bias electrode PE of the threshold voltage adjustable transistor, respectively. In this embodiment, the control terminal of the threshold voltage compensation transistor and the control terminal of the threshold voltage adjustable transistor are controlled by the same control signal. Therefore, when the threshold voltage adjustable transistor is turned on, the threshold voltage compensation transistor applies a bias voltage to the bias electrode of the threshold voltage adjustable transistor, achieving compensation or adjustment of the threshold voltage of the threshold voltage adjustable transistor.

As shown in Figure 6, the control terminal of the threshold voltage compensation transistor Mb is electrically connected to the output terminal or the input terminal of the shift register unit. The first and second terminals of the threshold voltage compensation transistor Mb are electrically connected to the bias voltage receiving terminal Vp and the bias electrode PE of the threshold voltage adjustable transistor respectively. In this embodiment, the control terminal of the threshold voltage compensation transistor receives the aforementioned input signal or output signal. Therefore, when the shift register unit receives an effective input signal In or outputs an effective output signal Out, the threshold voltage compensation transistor applies a bias voltage to the bias electrode PE of the threshold voltage adjustable transistor, achieving compensation or adjustment of the threshold voltage of the threshold voltage adjustable transistor.

The threshold voltage adjustable transistor mentioned above can be any transistor in the circuit schematic diagram of the shift register unit shown in Figure 2A, Figure 3, or Figure 4. In practice, different transistors in shift register units may experience different threshold voltage drifts. For example, in the case where the threshold voltage of the adjustable threshold voltage transistor MT undergoes positive threshold voltage drift, a positive bias voltage can be applied to the bias voltage receiving terminal Vp to control the threshold voltage of the adjustable threshold voltage transistor MT to shift negatively, thereby compensating for the positive threshold voltage drift, promoting the stability of the threshold voltage of the adjustable threshold voltage transistor MT, and improving the stability and reliability of the output scanning signal of the shift register unit. On the contrary, in the case of negative threshold voltage drift of the threshold voltage adjustable transistor MT, a negative bias voltage can be applied to the bias voltage receiving terminal Vp to control the threshold voltage of the threshold voltage adjustable transistor MT to shift positively, achieving compensation for the negative threshold voltage drift.

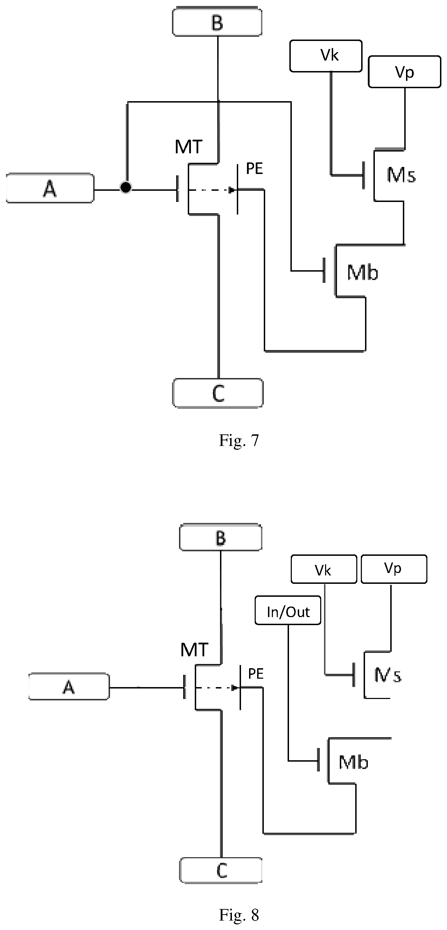

According to another embodiment of the application, the shift register unit further comprises a switch transistor connected in series with the threshold voltage compensation transistor, the switch transistor being configured for controlling whether the bias voltage is provided to the bias electrode of the threshold voltage adjustable transistor via the threshold voltage compensation transistor. Figures 7 and 8 illustrate examples of the electrical connection relationships among the threshold voltage compensation transistor, the threshold voltage adjustable transistor, and the switch transistor in the shift register unit. As shown in Figures 7 and 8, the shift register unit further comprises a switch transistor Ms, which is connected in series with the threshold voltage compensation transistor Mb. The switch transistor Ms controls whether the bias voltage received at the bias voltage receiving terminal is provided to the bias electrode of the threshold voltage adjustable transistor via the threshold voltage compensation transistor Mb. The control terminal of the switch transistor Ms is configured to receive a control signal Vk, and by utilizing different levels of the control signal Vk, the switch transistor Ms can be controlled to be in a turned-on state or an off state. In other words, in this embodiment, the switch transistor Ms or the control signal Vk may have a function for enabling the adjustment or compensation for the threshold voltage of the threshold voltage adjustable transistor. Therefore, the control signal Vk can also be referred to as a compensation enable signal. When there is no need to adjust or compensate for the threshold voltage of the adjustable threshold voltage transistor MT, the control signal Vk can be used to turn off the switch transistor Ms, thereby preventing over-compensation of the threshold voltage of the adjustable threshold voltage transistor and reducing power consumption. When to turn on the switch transistor Ms can be determined according to specific conditions. For example, after the shift register unit operating for a predetermined period of time, turning on the switch transistor Ms by means of the control signal Vk, thereby enabling the compensation or adjustment function of the threshold voltage compensation transistor Mb to the threshold voltage of the adjustable threshold voltage transistor. In other embodiments, node potentials and/or output signals of some shift register units in the gate driving circuit of the display device can be monitored, so as to determine whether to initiate compensation or adjustment of the threshold voltage of the threshold voltage adjustable transistor based on the waveforms of the node potentials and/or the waveform changes of the output signal.

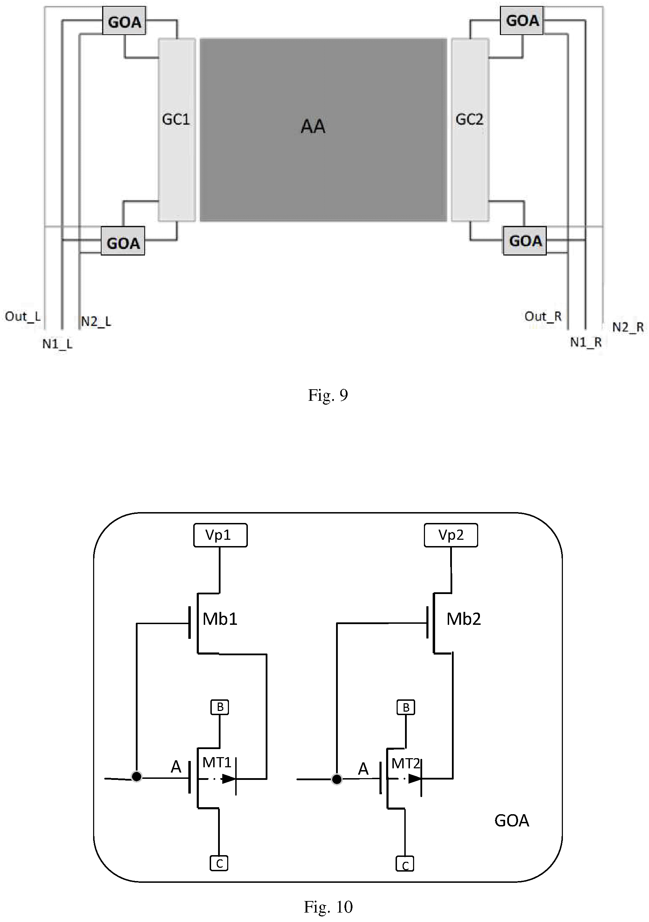

For example, Figure 9 illustrates a partial planar structural diagram of a display device according to an embodiment of the application. As shown in Figure 9, the display device includes a display area AA and a non-display area outside the display area AA. The display device includes gate driving circuits GC1 and GC2 in the non-display area. In this embodiment, the gate driving circuits GC1 and GC2 are distributed on two sides of the display area AA. The gate driving circuits GC1 and GC2 may include a plurality of shift register units, each shift register unit is the shift register unit described in any of the aforementioned embodiments. In addition, the display device includes a shift register unit located in at least one of the four corners of the display surface thereof. Figure 9 illustrates four shift register units arranged in the four corners of the display surface respectively, each of which has a module structure as shown in Figure 1 and is denoted by the reference sign GOA. As shown in Figure 9, signal lines are respectively led out from the first node N1, second node, and output terminal of each shift register unit GOA. The first nodes N1, the second nodes, and the output terminals of the two shift register units GOA on the left are electrically connected to the signal lines N1_L, N2_L, and Out_L, respectively. The first nodes N1, the second nodes, and the output terminals of the two shift register units GOA on the right are electrically connected to the signal lines N1_R, N2_R, and Out_R, respectively. Thus, the signals of the first node, the second nodes, and the output terminals of these four shift register units GOA can be monitored through these signal lines. When it is detected that the waveforms of these node potentials and/or the waveforms of the output signals deviate significantly from expected waveforms for these node potentials and output signals of the output terminals, compensation or adjustment of the threshold voltage of the adjustable threshold voltage transistor can be initiated.

Changes in the threshold voltages of the transistors in the shift register unit may vary depending on different transistors. For example, some transistors may experience positive threshold voltage drift, while others may experience negative threshold voltage drift. Different threshold voltage adjustments or compensations can be made for transistors with positive and negative threshold voltage drift. Therefore, in some embodiments, the threshold voltage adjustable transistor in the shift register unit includes a first type transistor with positive threshold voltage drift and a second type transistor with negative threshold voltage drift. The threshold voltage compensation transistor includes a first compensation transistor and a second compensation transistor. The bias voltage receiving terminal includes a first voltage receiving terminal and a second voltage receiving terminal. Therefore, different threshold voltage adjustments or compensations can be respectively made to the first type transistor and the second type transistor through the first voltage receiving terminal and the second voltage receiving terminal, as well as the first compensation transistor and the second compensation transistor, respectively.

Figure 10 illustrates the electrical connection between the first compensation transistor and the first type transistor, as well as the electrical connection between the second compensation transistor and the second type transistor in this embodiment. As shown in Figure 10, the shift register unit GOA includes a first type transistor MT1 with positive threshold voltage drift and a second type transistor MT2 with negative threshold voltage drift. The threshold voltage compensation transistor includes a first compensation transistor Mb1 and a second compensation transistor Mb2. The bias voltage receiving terminal includes a first voltage receiving terminal Vp1 and a second voltage receiving terminal Vp2. The control terminal of the first compensation transistor Mb1 is electrically connected to the control terminal A of the first type transistor MT1. The first and second terminals of the first compensation transistor Mb1 are electrically connected to the first voltage receiving terminal Vp1 and the bias electrode of the first type transistor MT1 respectively. The control terminal of the second compensation transistor Mb2 is electrically connected to the control terminal of the second type transistor. The first and second terminals of the second compensation transistor Mb2 are electrically connected to the second voltage receiving terminal Vp2 and the bias electrode of the second type transistor MT2 respectively. The first voltage receiving terminal Vp1 and the second voltage receiving terminal Vp2 are respectively configured to receive a first voltage and a second voltage different from each other. In some embodiments, the first type transistor includes at least one of the second transistor M2, the third transistor M3, and the seventh transistor M7 in the shift register unit shown in Figure 2A, and the second type transistor includes the first transistor M1 in the shift register unit shown in Figure 2A, with the first voltage being a positive voltage and the second voltage being a negative voltage. Thus, the threshold voltage of the first type transistor with positive threshold voltage drift can be decreased, while the threshold voltage of the second type transistor with negative threshold voltage drift can be increased. In the embodiment of Figure 10, the control terminal of the first compensation transistor is connected to the control terminal of the first type transistor, and the control terminal of the second compensation transistor is connected to the control terminal of the second type transistor. Alternatively, the first compensation transistor and the first type transistor can be controlled by different control signals, and the second compensation transistor and the second type transistor can be controlled by different control signals. For example, the control terminals of the first compensation transistor Mb1 and the second compensation transistor Mb2 can be electrically connected to the input terminal of the shift register unit to receive the input signal In or the output terminal to receive the output signal Out.

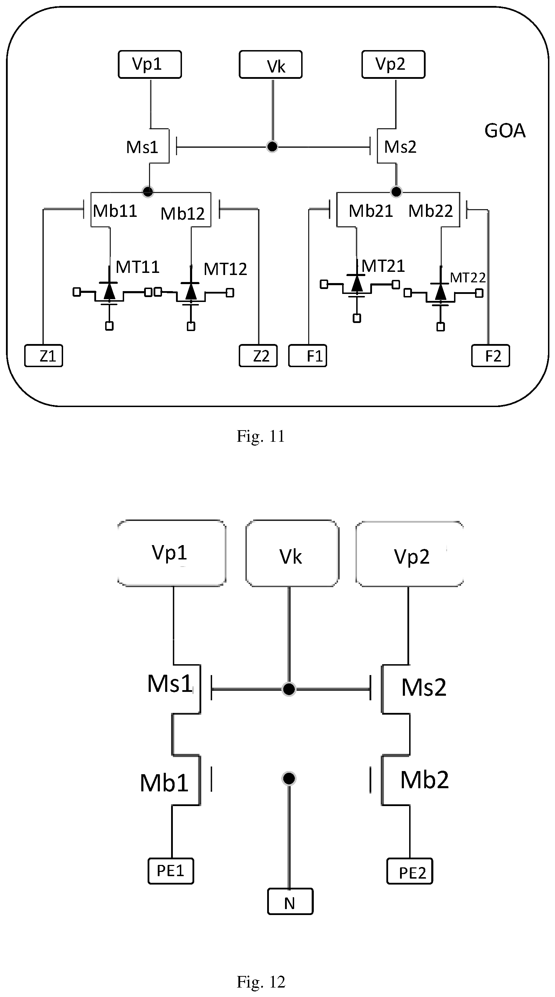

Figure 11 illustrates a partial circuit of a shift register unit according to another embodiment of the application. As shown in Figure 11, the shift register unit GOA includes first type transistors MT11 and MT12 with positive threshold voltage drift and second type transistors MT21 and MT22 with negative threshold voltage drift. The threshold voltage compensation transistor includes first compensation transistors Mb11 and Mb12 and second compensation transistors Mb21 and Mb22. The bias voltage receiving terminal includes a first voltage receiving terminal Vp1 and a second voltage receiving terminal Vp2. The shift register unit GOA also includes two switch transistors Ms1 and Ms2. The control terminals of the switch transistors Ms1 and Ms2 are both controlled by the control signal Vk. The first compensation transistors Mb11 and Mb12 are connected in parallel and then connected in series with the switch transistor Ms1. The second compensation transistors Mb21 and Mb22 are connected in parallel and then connected in series with the switching transistor Ms2. The control terminals of the first compensation transistors Mb11 and Mb12 are respectively connected to nodes Z1 and Z2. For example, nodes Z1 and Z2 can be electrically connected to the gates of the first type transistors MT11 and MT12, respectively. The control terminals of the second compensation transistors Mb21 and Mb22 are respectively connected to nodes F1 and F2. For example, nodes F1 and F2 can be electrically connected to the gates of the second type transistors MT21 and MT22, respectively. Therefore, when the control terminals of the switch transistors Ms1 and Ms2 receive an effective control signal Vk, and the control terminals of the first compensation transistors Mb11 and Mb12, and the second compensation transistors Mb21 and Mb22 receive effective control signals to turn on these switch transistors and compensation transistors, a first voltage (at this time, positive voltage) received at the first voltage receiving terminal Vp1 can be applied to the bias electrodes of the first type transistors MT11 and MT12 via the switch transistor Ms1 and the first compensation transistors Mb11 and Mb12, respectively, thereby compensating or adjusting the threshold voltage of the first type transistors MT11 and MT12. A second voltage (at this time, negative voltage) received at the second voltage receiving terminal Vp2 can be applied to the bias electrodes of the second type transistors MT21 and MT22 via the switch transistor Ms2 and the second compensation transistors Mb21 and Mb22, respectively, thereby compensating or adjusting the threshold voltage of the second type transistors MT21 and MT22.

Figure 12 illustrates a partial circuit diagram of a shift register unit according to another embodiment of the application. Similar to the previous embodiments, the threshold voltage adjustable transistor in the shift register unit includes a first type transistor with positive threshold voltage drift and a second type transistor with negative threshold voltage drift (the first and second type transistors are not shown in Figure 12). The threshold voltage compensation transistor includes a first compensation transistor Mb1 and a second compensation transistor Mb2, and the bias voltage receiving terminal includes a first voltage receiving terminal Vp1 and a second voltage receiving terminal Vp2. The control terminals of the first compensation transistor Mb1 and the second compensation transistor Mb2 are electrically connected to node N. The node N can be one of the first node, the input terminal of the input circuit, or the output terminal of the output circuit in the shift register unit discussed with reference to Figure 1. The first and second terminals of the first compensation transistor Mb1 are electrically connected to the first voltage receiving terminal Vp1 and the bias electrode PE1 of the first type transistor, respectively. The first and second terminals of the second compensation transistor Mb2 are electrically connected to the second voltage receiving terminal Vp2 and the bias electrode PE2 of the second type transistor, respectively. The first and second voltage receiving terminals are configured to receive first and second voltages different from each other. The signal at node N in Figure 12 can be the potential of the first node N1, the input signal In at the input terminal of the input circuit, or the output signal Out at the output terminal of the output circuit in the shift register unit discussed with reference to Figure 1.

Continuing with reference to Figure 12, in some embodiments, the switch transistor includes a first switch transistor Ms1 connected in series with the first compensation transistor Mb1, and a second switch transistor Ms2 connected in series with the second compensation transistor Mb2. The control terminals of the first switch transistor Ms1 and the second switch transistor Ms2 are electrically connected to a compensation enablement terminal that provides a compensation enablement signal Vk. Therefore, the compensation enablement signal Vk provided at the compensation enablement terminal can be used to control whether to initiate the compensation for the threshold voltages of the first type transistor and the second type transistor, and different voltages (first voltage and second voltage) can be used to make different compensation or adjustment to the threshold voltages of the first type transistor and the second type transistor respectively.

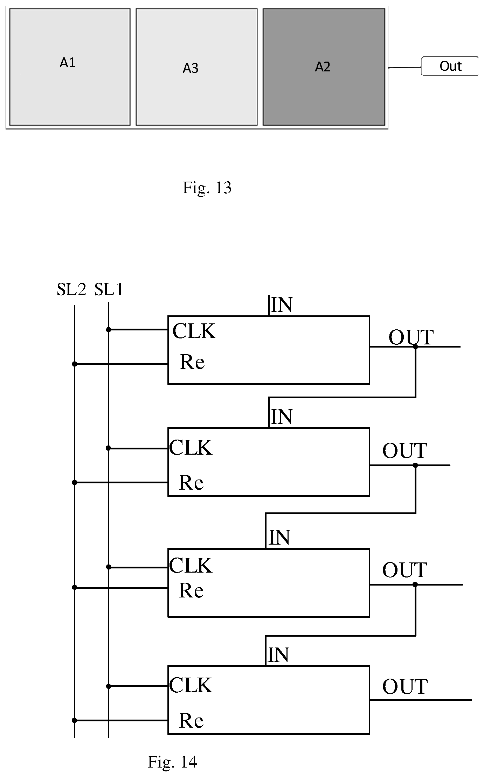

According to some embodiments of the application, the shift register unit comprises a base plate e for carrying the input circuit, the output circuit, the node potential control circuit, the discharge circuit, and the reset circuit, the base plate comprising a first area for arranging the first type transistor and a second area for arranging the second type transistor. The base layer of the threshold voltage adjustable transistor mentioned in the aforementioned embodiments can be a part of the base plate mentioned in this embodiment, that is, the base layer of the threshold voltage adjustable transistor can extend on a plane to form the base plate in this embodiment. Alternatively, in another embodiment, the base plate mentioned in this embodiment is a support structure different from the base layer of the threshold voltage adjustable transistor. In an embodiment, the first type transistors are centrally arranged in the first area, and the second type transistors are centrally arranged in the second area. That is to say, all transistors with positive threshold voltage drift in the shift register unit are arranged in the first area, while all transistors with negative threshold voltage drift are arranged in the second area different from the first area. Figure 13 illustrates the first area A1 and the second area A2 of the base plate of the shift register unit. All transistors in the shift register unit that experience positive threshold voltage drift are arranged in the first area A1. Therefore, the first area A1 can also be referred to as a positive threshold voltage drift compensation area, and the second area A2 can also be referred to as a negative threshold voltage drift compensation area. In this case, the same bias voltage (e.g. positive voltage) can be applied to the bias electrode of the first type transistors in the first area A1, and the same bias voltage (e.g. negative voltage) can be applied to the bias electrode of the second type transistors in the second area A2. Further, the integrated design of the bias electrodes of respective first type transistors and the integrated design of respective second type transistors can be achieved, which is conducive to simplifying the manufacturing process of the bias electrodes of threshold voltage adjustable transistors in the shift register unit.

In the embodiment of Figure 13, the base plate further includes a third area A3between the first area A1 and the second area A2. Transistors in the shift register unit that will not experience threshold voltage drift or whose operating performances are not prone to change can be centrally arranged in the third area A3. For transistors with insignificant threshold voltage shift or transistors not prone to experience threshold voltage shift, there is no need to compensate or adjust the threshold voltage. Therefore, the third area A3 can be referred to as a threshold voltage non-compensation area. By means of the region layout for respective transistors illustrated in the embodiment of Figure 13, it is possible to optimize the compensation of the threshold voltage of the adjustable threshold voltage transistor.

Next, with reference to Figures 2A and 3, the first and second type transistors will be explained exemplarily. As shown in Figure 2A or Figure 3, the input circuit includes a first transistor M1, the control terminal of the first transistor M1 is electrically connected to the input terminal, the first terminal of the first transistor M1 is electrically connected to the input terminal or the first control signal terminal (the terminal that receives the first control signal Vs1), and the second terminal of the first transistor M1 is electrically connected to the first node N1. The reset circuit includes a second transistor M2, the control terminal of the second transistor M2 is used to receive the reset signal Re. The first terminal of the second transistor M2 is electrically connected to the first node N1, and the second terminal of the second transistor M2 is electrically connected to the second control signal terminal (the terminal that receives the second control signal Vs2) or the first reference voltage terminal. The output circuit includes a third transistor M3, a fourth transistor M4, and a capacitor C. The control terminal of the third transistor M3 is electrically connected to the first node N1, the first terminal of the third transistor M3 is used to receive the clock signal CLK, and the second terminal of the third transistor M3 is electrically connected to the output terminal. The control terminal of the fourth transistor M4 is electrically connected to the second node N2, the first and second terminals of the fourth transistor M4 are electrically connected to the output terminal and the first reference voltage terminal respectively, and the capacitor C is electrically connected between the first node N1 and the output terminal. The node potential control circuit includes a fifth transistor M5 and a sixth transistor M6. The control terminal and first terminal of the fifth transistor M5 are electrically connected to the second reference voltage terminal, the second terminal of the fifth transistor M5 is electrically connected to the second node N2, the control terminal of the sixth transistor M6 is electrically connected to the first node N1, and the first and second terminals of the sixth transistor M6 are electrically connected to the second node N2 and the first reference voltage terminal respectively. The discharge circuit includes a seventh transistor M7, the control terminal of the seventh transistor is electrically connected to the second node N2, and the first and second terminals of the seventh transistor M7 are electrically connected to the first node N1 and the first reference voltage terminal respectively.

Through extensive experimental monitoring and research, the inventors of the application have realized that the second transistor M2, third transistor M3, and seventh transistor M7 in the shift register unit are prone to experience positive threshold voltage drift, while the first transistor M1 is prone to experience negative threshold voltage drift. Therefore, in this embodiment, the first type transistor includes the second transistor M2, the third transistor M3, or the seventh transistor M7, and the second type transistor includes the first transistor M1. The threshold voltages of the fourth transistor M4, the fifth transistor M5, and the sixth transistor M6 are less prone to drift. The second transistor M2, the third transistor M3, or the seventh transistor M7 can be centrally arranged in the aforementioned first area, while the fourth transistor M4, the fifth transistor M5, and the sixth transistor M6 are arranged in the aforementioned third area.

Another embodiment of the application provides a gate drive circuit comprising a plurality of shift register units as described in the foregoing embodiments, the shift register units are cascaded with each other to output a plurality of scan signals sequentially staggered in timing. Figure 14 illustrates four cascaded shift register units, each of which includes an input terminal for receiving an input signal IN, a clock signal input terminal for receiving a clock signal CLK, a reset terminal for receiving a reset signal Re, and an output terminal for providing an output signal OUT (i.e., a scanning signal). Additionally, the output signal OUT of the preceding shift register unit serves as the input signal IN provided to the adjacent succeeding shift register unit. Signal lines SL1 and SL2 respectively transmit the clock signal and the reset signal to each shift register unit.

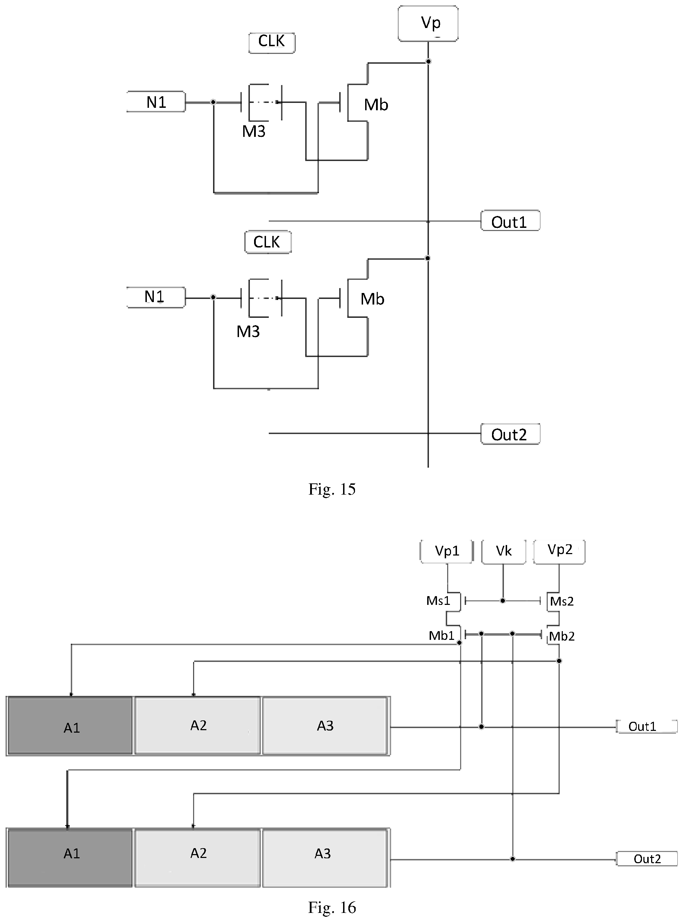

According to some embodiments of the application, the gate driving circuit further comprises a threshold voltage compensation circuit, which may include a plurality of threshold voltage compensation transistors corresponding to respective shift register units in the gate driving circuit. The control terminal of each threshold voltage compensation transistor is electrically connected to one of the output terminal, the input terminal, or the first node in a corresponding shift register unit. The first and second terminals of the threshold voltage compensation transistor are electrically connected to the bias voltage receiving terminal and the bias electrode of the threshold voltage adjustable transistor in the corresponding shift register unit respectively. For example, Figure 15 illustrates the electrical connection between the threshold voltage adjustable transistors M3 and the corresponding threshold voltage compensation transistors Mb in two cascaded shift register units.

According to another embodiment of the application, the threshold voltage compensation circuit in the gate driving circuit includes a threshold voltage compensation transistor and a bias voltage receiving terminal for receiving a bias voltage. The control terminal of the threshold voltage compensation transistor is electrically connected to one of the output terminal, the input terminal, or the first node in each shift register unit. The first and second terminals of the threshold voltage compensation transistor are electrically connected to the bias voltage receiving terminal and the bias electrode of the threshold voltage adjustable transistor in each shift register unit respectively. That is, in this embodiment, the same threshold voltage adjustable transistors or threshold voltage adjustable transistor (e.g., the first type transistor) with similar threshold voltage drift characteristics in the respective shift register units share a threshold voltage compensation transistor, thereby simplifying the design of the compensation circuit for the threshold voltage of the threshold voltage adjustable transistors in respective shift register units.

According to another embodiment of the application, the threshold voltage adjustable transistor comprises a first type transistor with positive threshold voltage drift and a second type transistor with negative threshold voltage drift. The threshold voltage compensation transistor comprises a first compensation transistor and a second compensation transistor. The bias voltage receiving terminal comprises a first voltage receiving terminal and a second voltage receiving terminal. The control terminals of the first compensation transistor and the second compensation transistor are electrically connected to one of the output terminal, the input terminal, or the first node in each shift register unit. The first and second terminals of the first compensation transistor are electrically connected to the first voltage receiving terminal and the bias electrode of the first type transistor respectively. The first and second terminals of the second compensation transistor are electrically connected to the second voltage receiving terminal and the bias electrode of the second type transistor respectively, the first and second voltage receiving terminals are respectively used to receive first and second voltages different from each other.

For example, Figure 16 illustrates two shift register units and a threshold voltage compensation circuit in a gate driving circuit. As shown in Figure 16, each shift register unit includes a base plate for carrying the input circuit, the output circuit, a node potential control circuit, the discharge circuit, and the reset circuit. The base plate includes a first area A1 for arranging the first type transistor and a second area A2 for arranging the second type transistor. The first area A1 includes first type transistors with positive threshold voltage drift, the second area A2 includes second type transistors with negative threshold voltage drift, and transistors whose threshold voltages do not require compensation or adjustment are arranged in the third area A3. As shown in Figure 16, the threshold voltage compensation transistor includes a first compensation transistor Mb1 and a second compensation transistor Mb2. The bias voltage receiving terminal includes a first voltage receiving terminal Vp1 and a second voltage receiving terminal Vp2. The control terminals of the first compensation transistor Mb1 and the second compensation transistor Mb2 are electrically connected to the output terminal of each shift register unit. The first and second terminals of the first compensation transistor Mb1 are electrically connected to the first voltage receiving terminal Vp1 and the bias electrode of the first type transistor respectively. The first and second terminals of the second compensation transistor Mb2 are electrically connected to the second voltage receiving terminal Vp2 and the bias electrode of the second type transistor respectively. The first voltage receiving terminal Vp1 and the second voltage receiving terminal Vp2 are respectively used to receive first and second voltages different from each other. In the embodiment of Figure 16, the transistors in each shift register unit are arranged in different areas according to threshold voltage drift characteristics thereof. By means of the first compensation transistor Mb1 and the second compensation transistor Mb2, targeted compensation or adjustment of the threshold voltage of transistors in different areas can be achieved. For example, the first voltage received at the first voltage receiving terminal Vp1 can be a positive voltage to promote the threshold voltage of the first type transistor in the first area A1 to negatively shift (reducing the threshold voltage), and the second voltage received at the second voltage receiving terminal Vp2 can be a negative voltage to promote the threshold voltage of the second type transistor in the second area A2 to positively shift (increasing the threshold voltage). Moreover, respective shift register units can share a threshold voltage compensation circuit, which is conducive to simplifying the structure of the gate driving circuit. In Figure 16, the control terminals of the first compensation transistor Mb1 and the second compensation transistor Mb2 are electrically connected to the output terminals Out1 and Out2 in the shift register units. However, in other embodiments, the control terminals of the first compensation transistor Mb1 and the second compensation transistor Mb2 are electrically connected to the input terminals or first nodes in the shift register units.

Continuing with reference to Figure 16, according to some embodiments of the application, the threshold voltage compensation circuit further comprises a first switch transistor Ms1 connected in series with the first compensation transistor Mb1, and a second switch transistor Ms2 connected in series with the second compensation transistor Mb2. The control terminals of the first switching transistor Ms1 and the second switching transistor Ms2 are electrically connected to a compensation enablement terminal that provides the compensation enablement signal Vk. Therefore, with the compensation enablement signal Vk received by the compensation enablement terminal, the first switch transistor Ms1 and the second switch transistor Ms2 can be controlled to be turned on or off, thereby controlling whether to apply corresponding bias voltages to the bias electrodes of the threshold voltage adjustable transistors in each shift register unit, facilitating control by the user over whether to enable the threshold voltage compensation function.

It should be understood that although the terms "first", "second", "third" and so on may be used herein to describe various devices, components, parts, or sections, these devices, components, parts, or sections should not be limited by these terms, they merely serve as names for distinction. Additionally, the term "electrical connection" as mentioned herein includes both "direct connection" and "indirect connection." Although the technical solution of the application has been described in conjunction with some embodiments, the scope of protection of the application is not limited to the specific forms disclosed herein, and the scope of the application is defined by the appended claims.

## Claims

1. A shift register unit, **characterized in that** the shift register unit comprises:
an input circuit configured to be electrically connected to an input terminal and a first node, so as to control a potential of the first node based on an input signal received at the input terminal;
an output circuit configured to receive a clock signal and be electrically connected to the first node, a second node, an output terminal and a first reference voltage terminal, so as to, under the control of the potential of the first node and a potential of the second node, provide an output signal to the output terminal based on the clock signal;
a node potential control circuit configured to be electrically connected to the first node, the second node, the first reference voltage terminal and a second reference voltage terminal, so as to control the potential of the second node based on a second reference voltage at the second reference voltage terminal and the potential of the first node;
a discharge circuit configured to be electrically connected to the first node, the second node and the first reference voltage terminal, so as to discharge the first node under the control of the potential of the second node; and
a reset circuit configured to receive a reset signal and be electrically connected to the first node, so as to reset the first node under the control of the reset signal,
wherein at least one of the input circuit, the output circuit, the node potential control circuit, the discharge circuit and the reset circuit comprises a threshold voltage adjustable transistor, the threshold voltage adjustable transistor comprising a substrate, a gate, a source-drain electrode and a bias electrode, wherein the source-drain electrode is at a side of the substrate facing the gate, the bias electrode is at a side of the substrate facing away from the gate, the bias electrode is configured to receive a bias voltage to adjust a threshold voltage of the threshold voltage adjustable transistor.

2. The shift register unit according to claim 1, **characterized in that** the threshold voltage adjustable transistor further comprises an active layer between the gate and the source-drain electrode, and a base layer for carrying the gate, wherein an orthographic projection of the bias electrode on the base layer covers an orthographic projection of the active layer on the base layer.

3. The shift register unit according to claim 2, **characterized in that** the threshold voltage adjustable transistor further comprises a gate insulation layer, the gate insulation layer is between the source-drain electrode and the base layer and covers the gate.

4. The shift register unit according to claim 1, **characterized in that** the shift register unit further comprises a threshold voltage compensation transistor and a bias voltage receiving terminal for receiving the bias voltage, a control terminal of the threshold voltage compensation transistor is electrically connected to one of a control terminal of the threshold voltage adjustable transistor, the input terminal, an output terminal of the output circuit, wherein a first terminal and a second terminal of the threshold voltage compensation transistor are electrically connected to the bias voltage receiving terminal and the bias electrode of the threshold voltage adjustable transistor respectively.

5. The shift register unit according to claim 4, **characterized in that** the shift register unit further comprises a switch transistor connected in series with the threshold voltage compensation transistor, the switch transistor is configured to control whether the bias voltage is provided to the bias electrode of the threshold voltage adjustable transistor via the threshold voltage compensation transistor.

6. The shift register unit according to claim 4, **characterized in that** the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal,
wherein a control terminal of the first compensation transistor is electrically connected to a control terminal of the first type transistor, a first terminal and a second terminal of the first compensation transistor are electrically connected to the first voltage receiving terminal and the bias electrode of the first type transistor respectively, a control terminal of the second compensation transistor is electrically connected to a control terminal of the second type transistor, a first terminal and a second terminal of the second compensation transistor are electrically connected to the second voltage receiving terminal and the bias electrode of the second type transistor respectively, wherein the first voltage receiving terminal and the second voltage receiving terminal are respectively configured to receive a first voltage and a second voltage different from each other.

7. The shift register unit according to claim 4, **characterized in that** the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal,
wherein a control terminal of the first compensation transistor and a control terminal of the second compensation transistor are electrically connected to one of the first node, an input terminal of the input circuit or an output terminal of the output circuit, a first terminal and a second terminal of the first compensation transistor are electrically connected to the first voltage receiving terminal and the bias electrode of the first type transistor respectively, a first terminal and a second terminal of the second compensation transistor are electrically connected to the second voltage receiving terminal and the bias electrode of the second type transistor respectively, wherein the first voltage receiving terminal and the second voltage receiving terminal are respectively configured to receive a first voltage and a second voltage different from each other.

8. The shift register unit according to claim 6 or 7, **characterized in that** the shift register unit comprises a base plate for carrying the input circuit, the output circuit, the node potential control circuit, the discharge circuit and the reset circuit, the base plate comprises a first area for arranging the first type transistor and a second area for arranging the second type transistor.

9. The shift register unit according to claim 6 or 7, **characterized in that** the switch transistor comprises a first switch transistor connected in series with the first compensation transistor and a second switch transistor connected in series with the second compensation transistor, a control terminal of the first switch transistor and a control terminal of the second switch transistor are electrically connected to a compensation enablement terminal providing a compensation enablement signal.

10. the shift register unit according to claim 8, **characterized in that** the input circuit comprises a first transistor, a control terminal of the first transistor is electrically connected to the input terminal, a first terminal of the first transistor is electrically connected to the input terminal or a first control signal terminal, a second terminal of the first transistor is electrically connected to the first node,
the reset circuit comprises a second transistor, a control terminal of the second transistor is configured to receive a reset signal, a first terminal of the second transistor is electrically connected to the first node, a second terminal of the second transistor is electrically connected to a second control signal terminal or the first reference voltage terminal,
the output circuit comprises a third transistor, a fourth transistor and a capacitor, a control terminal of the third transistor is electrically connected to the first node, a first terminal of the third transistor is configured to receive the clock signal, a second terminal of the third transistor is electrically connected to the output terminal, a control terminal of the fourth transistor is electrically connected to the second node, a first terminal and a second terminal of the fourth transistor are electrically connected to the output terminal and the first reference voltage terminal respectively, the capacitor is electrically connected between the first node and the output terminal,
the node potential control circuit comprises fifth transistor and a sixth transistor, a control terminal and a first terminal of the fifth transistor is electrically connected to the second reference voltage terminal, a second terminal of the fifth transistor is electrically connected to the second node, a control terminal of the sixth transistor is electrically connected to the first node, a first terminal and a second terminal of the sixth transistor are electrically connected to the second node and the first reference voltage terminal respectively,
the discharge circuit comprises a seventh transistor, a control terminal of the seventh transistor is electrically connected to the second node, a first terminal and a second terminal of the first transistor are electrically connected to the first node and the first reference voltage terminal respectively,
wherein the first type transistor comprises the second transistor, the third transistor and the seventh transistor, the second type transistor comprises the first transistor.

11. The sift register unit according to claim 10, **characterized in that** the base plate further comprises a third area, the fourth transistor, the fifth transistor and the sixth transistor are arranged in the third area.

12. A gate driving circuit comprising a plurality of cascaded shift register units, each shift register unit is as claimed in any one of claims 1-3, **characterized in that** the gate driving circuit further comprises a threshold voltage compensation circuit, the threshold voltage compensation circuit comprising a threshold voltage compensation transistor and a bias voltage receiving terminal for receiving the bias voltage,
wherein a control terminal of the threshold voltage compensation transistor is electrically connected to one of the output terminal, the input terminal or the first node of the shift register unit, a first terminal and a second terminal of the threshold voltage compensation transistor are electrically connected to the bias voltage receiving terminal and the bias electrode of the threshold voltage adjustable transistor in the shift register unit respectively.

13. The gate driving circuit according to claim 12, **characterized in that** the threshold voltage adjustable transistor comprises a first type transistor with positive threshold voltage drift and a second type transistor with negative threshold voltage drift, the threshold voltage compensation transistor comprises a first compensation transistor and a second compensation transistor, the bias voltage receiving terminal comprises a first voltage receiving terminal and a second voltage receiving terminal, wherein a control terminal of the first compensation transistor and a control terminal of the second compensation transistor are electrically connected to one of the output terminal, the input terminal or the first node of each shift register unit, a first terminal and a second terminal of the first compensation transistor are electrically connected to the first voltage receiving terminal and the bias electrode of the first type transistor respectively, a first terminal and a second terminal of the second type transistor are electrically connected to the second voltage receiving terminal and the bias electrode of the second type transistor respectively, wherein the first voltage receiving terminal and the second voltage receiving terminal are respectively configured to receive a first voltage and a second voltage different from each other.

14. The gate driving circuit according to claim 13, **characterized in that** the threshold voltage compensation circuit further comprises a first switch transistor connected in series with the first compensation transistor and a second switch transistor connected in series with the second compensation transistor, a control terminal of the first switch transistor and a control terminal of the second switch transistor are electrically connected to a compensation enablement terminal providing a compensation enablement signal.

15. The gate driving circuit according to claim 13, **characterized in that** each shift register unit comprises a base plate for carrying the input circuit, the output circuit, the node potential control circuit, the discharge circuit and the reset circuit, the base plate comprising a first area for arranging the first type transistor and a second area for arranging the second type transistor.

16. A display device comprising a gate driving circuit as claimed in any one of claims 12-15.
